# EUROPEAN PATENT SPECIFICATION

(11) **EP 0 424 375 B1**
(45) Date of publication and mention of the grant of the patent: **13.10.1993**
(21) Application number: 88909414.0
(22) Date of filing: 30.08.1988
(51) Int. Cl.: G03F 1/00

(54) **MONOLITHIC CHANNELING MASK HAVING AMORPHOUS/SINGLE CRYSTAL CONSTRUCTION**
MONOLITISCHE TUNNELMASKE MIT EINER AMORPHEN/EINKRISTALLINEN STRUKTUR
MASQUE DE CANALISATION MONOLITHIQUE AYANT UNE CONSTRUCTION DE CRISTAUX AMORPHES/MONOCRISTAUX

(30) Priority: 09.10.1987 US 106285
(43) Date of publication of application: 02.05.1991
(73) Proprietor: Hughes Aircraft Company, Los Angeles, California 90045-0066 (US)
(72) Inventor: ATKINSON, Gary, M., Santa Monica, CA 90403 (US)
(74) Representative: KUHNEN, WACKER & PARTNER
(86) International application number: US8802961
(87) International publication number: WO8903544

(56) References cited:
- Journal of Vacuum Science & Technology B, volume 5, no. 1, January/February 1987, American Vacuum Society, (Woodbury, NY, US), E.J. Parma, Jr et al.: "Channeling transmission of protons through thin silicon membranes", pages 228-231
- IBM Technical Disclosure Bulletin, volume 25, no. 11B, April 1983, (New York, US), E. Bassous et al.:"Triple layer system for high resolution microlithpgraphy", pages 5916-5917
- Research Disclosure , no. 274, February 1987, (New York, US), "X-ray mask/membrane fabrication", page 116, disclosure no. 27481
- IBM Technical Disclosure Bulletin, volume 23, no. 10 March 1981, (New York, US), J.H. keller et al.: "Fabrication technique for an ion beam lithgraphy mask in tensile stress", pages 4486-4488
- Extended Abstracts, volume 82, no. 1, May 1982, (Pennington, New Jersey, US), J. Bartelt et al.: "Membrane mask considerations in ion beam lithgraphy", pages 454-455
- IBM Technical Disclosue Bulletin, volume 24, no. 12, May 1982, (New York, US), C.R. Guarnieri et al.: "Fabrication of an improved membrane substrate", pages 6270-6271

## Description

### BACKGROUND OF THE INVENTION

This invention relates to a process for preparing a membrane channeling mask according to claim 1, a mask prepared by such process according to claim 11, and the use of such process and such mask for preparing an integrated circuit according to claim 12. In particular, this invention relates to the preparation of integrated electronic circuits, and, more particularly, to the preparation of integrated circuits by lithography techniques and fabrication of the masks used in the lithography.

From Journal of Vacuum Science of Technology B, vol. 5, No. 1 January/February 1987, American Vacuum Society, pages 228-231, thin silicon membranes for the use in masked ion beam lithography are known. The membranes are (100) silicon, 0,1-10 micrometer thick, and are fabricated by boron diffusion of the substrate and subsequent etching of the substrate up to the boron layer. In the concentration of ca. 10¹⁹ atoms/cm³, boron acts as an etch stop by which thin uniform membrane windows can be produced. Some of the membranes are produced by growing an epitaxial layer of boron-doped silicon on the substrate which was subsequently etched.

From IBM, Technical disclosure bulletin, vol. 25, No. 11B, April 1983, pages 5916 to 5917, it is disclosed to use a amorphous silicon layer as a film opaque to ultraviolet radiation in a triple layer system for patterning sub-micron features over sharp steps on a surface.

Integrated circuits are electronic devices having multiple layers of various electronically active materials, processed so as to form discrete devices in the layers and in a number of adjacent layers. The integrated circuits are sometimes prepared using lithography techniques, wherein a layer of a semiconductor material is deposited on a surface, a pattern is applied to the deposited layer by an appropriate technique using flood illumination of the surface, a portion of the layer defined by the applied pattern is removed by etching, and another layer of semiconductor material is deposited. Other steps such as the formation of external contacts may be interspersed with the repeated deposition, patterning and etching procedure. Through judicious design of the integrated circuits and careful attention to the fabrication techniques, large, complex circuits can be fabricated in very small areas by this approach.

A continuing trend in the field of integrated circuit technology is the reduction in size of the devices and the packing of higher densities of devices into single integrated circuits on a chip. Devices are now fabricated with individual elements having sizes less than a micrometer. The advantages of such smaller devices are increased speed, reduced cost, and greater capability on a chip.

One key obstacle that previously limited the size of integrated circuit devices was the photolithography process used to define patterns on the surfaces of deposited layers of semiconductor materials. When lithography using illuminating wavelengths in the visible of near-visible range is employed, the wave diffraction effects of the long wavelength radiation tend to blur the images and reduce the resolution of the lithography. The smallest feature that can be fabricated using photolithography for mass production of integrated circuits is about 0.75 micrometers.

The problem arising from using radiation in the visible and near-visible range has been solved by using ion beam and x-ray lithography techniques, wherein the illuminating radiation used has a much shorter wavelength than light. Suitable resist, developing and etching techniques are available, and ion beam, electron beam, and x-ray lithography have been demonstrated for fabrication of integrated circuits with devices having 0.1 to 0.5 micrometer features.

In ion beam and x-ray lithography techniques, a mask is prepared having an exposure pattern that is transparent to the illuminating radiation in areas corresponding to locations on the semiconductor to be exposed, and is opaque to the illuminating radiation in areas corresponding to those that are not to be exposed. The mask is placed over the semiconductor material to be patterned and etched, and the illuminating radiation exposes a resist layer on the surface of the semiconductor through the exposure pattern on the mask. The resist material is then developed and the pattern transferred to the semiconductor by etching. The mask can be reused to pattern another circuit, as it is a separate structure from the wafer being patterned.

The materials used in masks for light photolithography are conventional light absorbing materials, which are unacceptable for masking ion beams or x-rays. Masks used in ion beams and x-ray lithography are made of materials that are radiation transparent or radiation absorbent in selected areas of masks that are themselves thin, on the order of at most about 2 to 5 micrometers in thickness.

In one common approach, the masks for ion beam lithography use gold (or tungsten) patterns of a thickness such that the ion beam is blocked and absorbed in the opaque portions of the mask, and with pattern openings therethrough as required. The gold patterns are supported on a thin silicon membrane, so that isolated absorbing areas of the mask are possible. The silicon membrane is sufficiently thin that it transmits the incident ion beam or x-rays with minimum absorption and scattering. The process used to fabricate the masks is complex, with over 20 process steps, and has a limited yield of successfully fabricated masks.

The gold-absorber masks have certain limitations in use. Since the mask employs two different materials, gold and silicon, bonded together, the mask behaves much like a bimetallic strip such as a thermostat element due to the different thermal expansion parameters of the materials. The mask inherently displays high internal thermal stresses after fabrication, and further internal thermal stresses develop in repeated heating and cooling cycles during its use in ion beam or x-ray lithography. The mask is repeatedly exposed to radiation in use, and the absorbed radiation heats the mask. The heating of the mask causes it to bend due to the differential thermal expansion, further warping the mask and distorting the pattern thereupon. Each component of warpage and distortion reduces the pattern resolution and pattern registry that can be achieved using the mask, thereby impairing the ability to fabricate small, precise devices using the mask.

More recently, layered, all-silicon masks have been prepared, wherein both the pattern window and the absorber material are silicon or silicon-based materials. The thermal expansion coefficients of the various layers are therefore closer in value to each other than in the prior gold-silicon masks, reducing the amount of distortion experienced in fabrication and use. The results obtained with these all-silicon masks are significantly better than with the prior masks. However, small mask distortions are observed, with the result that there remains a degree of fuzziness, a lack of linewidth resolution, and a degree of overlay inaccuracy in wafers irradiated with the finished mask.

The problems just discussed must be resolved to achieve further advances in reducing the size of circuits produced by lithographic techniques. Any solution must utilize materials and processing that are sufficiently economic and productive to be competitive for the many masks needed in the commercial fabrication of complex integrated circuits having thousands of devices, and requiring tens of separate deposited layers, in a single chip.

Accordingly, there is a need for an improved structure for an ion beam and x-ray lithography mask, and a process for fabricating and using such an improved mask. The mask should reduce mask distortion during fabrication and use, and permit improved device element resolution. The fabrication process desirably would have a significantly reduced number and complexity of steps, so as to be more economical and have a higher yield of good masks. The present invention fulfills this need, and further provides related advantages.

### SUMMARY OF THE INVENTION

An inventive process for preparing a membrane channeling mask is indicated in claim 1. A mask prepared by such process is indicated in claim 11, and the use of such process and such mask for preparing an integrated circuit is indicated in claim 12.

The present invention is embodied in a process for fabricating masks used in ion beam and x-ray lithography, the structure of such masks, and a process for using the masks. The masks of the invention are operable in lithography techniques using existing resist technology. The exposure pattern is etched into the mask with great precision, both as to width and depth. The masks are fabricated by applying processing steps that have been individually proved in other contexts. A reduced number of processing steps is required in fabricating the masks, and the critical patterning operation comes last, so that the yield of acceptable masks is improved. The masks themselves produce superior devices by lithography, because of their reduced warpage, due to lower internal relaxation and differential expansion stresses upon heating, which improves pattern registration accuracy and linewidth resolution.

In accordance with the invention, A process for preparing a membrane channeling mask having an exposure pattern therein comprises the steps of furnishing a wafer of crystalline silicon; providing a layer of epitaxial p-doped silicon at a first surface of the wafer of silicon, the dopant ion having an ionic size smaller than that of silicon; providing a layer of amorphous silicon overlying the p-doped silicon layer; etching a window to the p-doped silicon layer through the undoped silicon wafer, the window having a lateral extent at least as large as the exposure pattern and extending through the thickness of the silicon wafer to the layer of p-doped silicon, to form a membrane; and etching the exposure pattern through the layer of amorphous silicon, to the layer of p-doped silicon to form thin transmitting regions and thicker absorber patterns.

In a preferred embodiment, a silicon dioxide "etch stop" layer is provided between the p-doped silicon layer and the amorphous silicon layer. Silicon nitride patterning layers are also added overlying the amorphous silicon layer and the silicon wafer, to aid in patterning the mask.

In accordance with the preferred embodiment, a process for preparing a membrane channeling mask having an exposure pattern therein comprises the steps of furnishing a wafer of crystalline silicon; providing a layer of epitaxial p-doped silicon at a first surface of the wafer of silicon, the dopant ion having an ionic size smaller than that of silicon; providing a layer of silicon dioxide overlying the layer of p-doped silicon; providing a layer of amorphous silicon overlying the layer of silicon dioxide; providing a layer of silicon nitride overlying the layer of amorphous silicon; providing a layer of silicon nitride overlying a second surface of the wafer of crystalline silicon; etching a window to the p-doped silicon layer through the undoped silicon wafer, the window having a lateral extent at least as large as the exposure pattern and extending through the thickness of the silicon wafer to the layer of p-doped silicon, to form a membrane; and etching the exposure pattern through the layer of amorphous silicon and the layer of silicon dioxide, to the layer of p-doped silicon to form thin transmitting regions and thicker absorber patterns.

The mask of the preferred form of the present invention is made entirely of silicon and silicon-doped materials. Although there are relatively minor differences in the thermal expansion coefficients of the various layers in the final mask, these differences are significantly less than the differences in thermal expansion coefficients of prior masks that might have, for example, silicon and gold layers in contact. As a result, the thermal expansion strains of the present mask are significantly reduced, thereby reducing the warping of the mask during fabrication and use. Reduction of the warping leads to higher precision and resolution of the exposure pattern formed in the mask itself, and of the irradiated pattern on the semiconductor surface patterned using the mask. Selective doping and selection of particular layer thicknesses can also be used to control warping of the mask, as will be described.

Even with the use of an all-silicon mask, sources of warpage and distortion remain, and the present approach permits the control of these sources. Polished silicon wafers ordinarily are bowed due to internal stresses. The deposition of a controlled thickness of the p-doped silicon layer can be used to apply a stress that tends to reduce the bowing, and at the same time creates an internal tensile stress in the p-doped silicon layer. A controlled level of internal stress in the p-doped silicon layer is desirable, as it exerts a preloading in the mask that resists distortion due to thermal loadings, when the mask is later used. Thus, shape distortion of the mask can be controlled through selection of the dopant, level of doping, and thickness of the p-doped silicon layer.

Another important potential source of distortion is the relaxation and irregular etching that occurs in the sidewalls of the absorbing pattern as the absorbing layer is etched away in the shape of the mask pattern. The relaxation causes a change in the intended width of the pattern openings, with a consequent loss of resolution of the linewidths when the mask is used in exposing substrates. The amorphous silicon absorber layer of the present invention reduces this sources of distortion in several ways. The amorphous silicon is a better absorber of ion beam radiation, so that it can be made thinner than can a crystalline absorber layer. The thinner the layer, the less scattering of the ion beam and consequent resolution loss. In combination with the control of thermal distortion resulting from use of the p-doped silicon layer, the amorphous silicon layer can be applied in a low-stress state, so that there is little driving force for sidewall relaxation. In combination with the p-doped silicon layer, the amorphous silicon therefore provides significant benefits in reduced distortion of the mask.

The use of amorphous silicon, rather than crystalline silicon, also permits the sides of the etched pattern to be etched steeply vertical, resulting in a precise mask pattern and excellent linewidth control of the pattern transferred to the semiconductor device. Crystalline silicon etches somewhat irregularly along crystallographic planes, so that the etched pattern is jagged, sometimes irregular, and sometimes shallowly inclined if a rapidly etching plane is exposed. The amorphous silicon has no crystalline structure, with the result that etching follows the path defined by the etching process, rather than the path defined in part by the material being etched.

During the fabrication process as described, a pattern is etched downwardly through the amorphous silicon layer to the p-doped silicon layer. The silicon dioxide layer, preferably provided between the amorphous silicon layer and the p-doped silicon layer, acts as an etch stop in this etch step, permitting precise control of the thickness of the absorber layer and transmitting regions.

The crystallographic orientation of the wafer of silicon (and thence the p-doped silicon layer that forms the portion of the mask through which the ion beam passes) is selected to permit channeling of the transmitted beam, and is preferably (001) or (011), as defined by conventional Miller indices. The ion beam is channeled along the [001] or [011] directions in the crystal lattice with minimal scattering. Other orientations also exhibit the channeling effect and can be used.

The wafer of silicon is typically about 300 to 500 micrometers thick initially. A layer preferably about 2 to 3 micrometers thick having a p-type silicon dopant of a smaller ionic size than the silicon, to induce a small internal tensile stress in the finished mask, is added to the top surface of the wafer of silicon, preferably by epitaxial growth. After deposition of the amorphous silicon layer, a window is etched from the other surface of the silicon wafer to the p-doped silicon layer, preferably by depositing a window layer of silicon nitride and forming an opening of the lateral size of the window in the silicon nitride layer. Removal of the undoped silicon is conveniently accomplished through the opening in the silicon nitride layer with a selective anisotropic alkaline etch such as sodium hydroxide, potassium hydroxide or ethylenediamine pyrocatechol, that does not rapidly attack the p-doped silicon. The membrane is therefore formed before any patterning and etching of the exposure pattern is undertaken, so that internal distortions are compensated before the exposure pattern is formed. The net distortion of the exposure pattern is thereby reduced, as compared with the alternative approach of window etching to form the membrane after the exposure pattern is etched.

The technique used to deposit silicon nitride on the bottom surface of the silicon piece readily deposits a silicon nitride layer on the top exposed surface, over the amorphous silicon layer. This top layer of silicon nitride is preferably present, to assist in subsequent etching steps, but is not absolutely necessary. At this stage, the mask is preferably mounted on a glass support ring having a coefficient of thermal expansion matched to that of the silicon wafer, for strength and ease of handling.

The pattern of the mask is transferred to the upper surface of the silicon nitride by any operable technique, with electron beam lithography being preferred. An electron-beam resist layer is applied to the upper exposed surface, and the pattern is written onto the resist layer by a programmed electron beam. The electron beam resist is developed, and the amorphous silicon layer (and silicon dioxide layer, where present) is removed down to the p-doped silicon layer, in the portions of the resist layer that are removed to form the mask exposure pattern, as by magnetron assisted reactive ion etching. The silicon dioxide layer, when present is an etch stop that limits the depth of the reactive ion etching. The silicon dioxide layer is in turn removed with a buffered hydrofluoric acid solution that also removes the silicon nitride layers.

During later lithography procedures using the mask, the resulting thin regions of the membrane transmit the portion of the ion or x-ray beam that is intended to be transmitted to the resist layer on the semiconductor, while a combination of the thicker regions of the p-doped silicon membrane and the amorphous silicon layer absorb the portion of the beam that is to be masked. Optionally, a very thin emissive layer, such as a nickel-chromium alloy, can be added to the upper surface of the mask to radiate heat from the mask when in use.

The principles of the invention can be applied more broadly than the embodiments just described, which are based upon the use of silicon as the mask material. Other crystalline mask materials that exhibit channeling, and can be provided in amorphous and doped forms, may be used in place of silicon. Such materials include, for example, silicon carbide, sapphire, and beryl. In masks made from another mask material, the crystalline form of the mask material is used in place of crystalline silicon, the doped form of the mask material is used in place of doped silicon, and the amorphous form of the mask material is used in place of amorphous silicon. It is important that the doped layer of mask material be doped with ions of a size such that the layer of doped mask material is in tension, which normally means that a relatively small ion is used to dope the mask material.

Thus, in accordance with the invention, a process for preparing a membrane channeling mask having an exposure pattern therein comprises the steps of furnishing a wafer of a crystalline mask material; providing a layer of doped mask material at one surface of the wafer of mask material, the dopant ion having an ionic size such that the layer of doped mask material is in tension; providing a layer of amorphous mask material overlying the layer of doped mask material; etching a window to the layer of doped mask material through the undoped mask material wafer, the window having a lateral extent at least as large as the exposure pattern and extending through the thickness of the mask material wafer to the layer of doped mask material; and etching the exposure pattern through the layer of amorphous mask material to the layer of doped mask material.

The masks produced by the present process are unique, and no other masks are known to have their combination of high resolution, low distortion, and perfection when used in ion beam and x-ray lithography.

The present invention also extends to the process for patterning the semiconductor devices, using the embodiments of the mask described herein. A process for applying a pattern to a substrate during masked ion beam lithography in integrated circuit fabrication comprises the steps of furnishing a monolithic p-doped silicon single crystal mask including an amorphous silicon layer and having an exposure pattern partially therethrough, the mask having no metallic absorber layer deposited thereupon; and exposing the substrate to radiation through the exposure pattern of the silicon mask. The mask can be prepared with the structure and by the techniques previously set forth. The resulting exposure patterns in the exposed substrates have the excellent linewidth control discussed previously. In a broader form, any suitable mask material may be used in place of silicon, as previously described.

It will now be appreciated that the present invention provides a significant advance in the art of fabrication of masks for use in ion beam and x-ray lithographic processes for the production of integrated circuits. The masks require fewer production steps and have a higher yield in production, reducing their cost. The masks also have improved performance due to lower internal relaxation strains produced during fabrication, and particularly due to their greatly reduced tendency to warp and distort when repeatedly heated by the beam during exposure in the lithographic process. Other features and advantages of the present invention will be apparent from the following more detailed description, taken in conjunction with the accompanying drawings, which illustrates, by way of example, the principles of the invention.

### BRIEF DESCRIPTION OF THE DRAWINGS

Figure 1 is a side elevational view of apparatus for patterning substrates using masked ion beam lithography;
Figure 2 is a side elevational view of a mask structure; and
Figure 3A-3D is a schematic flow diagram for a process for producing channeling masks, illustrating the structure of the mask of the present invention at the different steps of the process.

### DETAILED DESCRIPTION OF THE PREFERRED EMBODIMENT

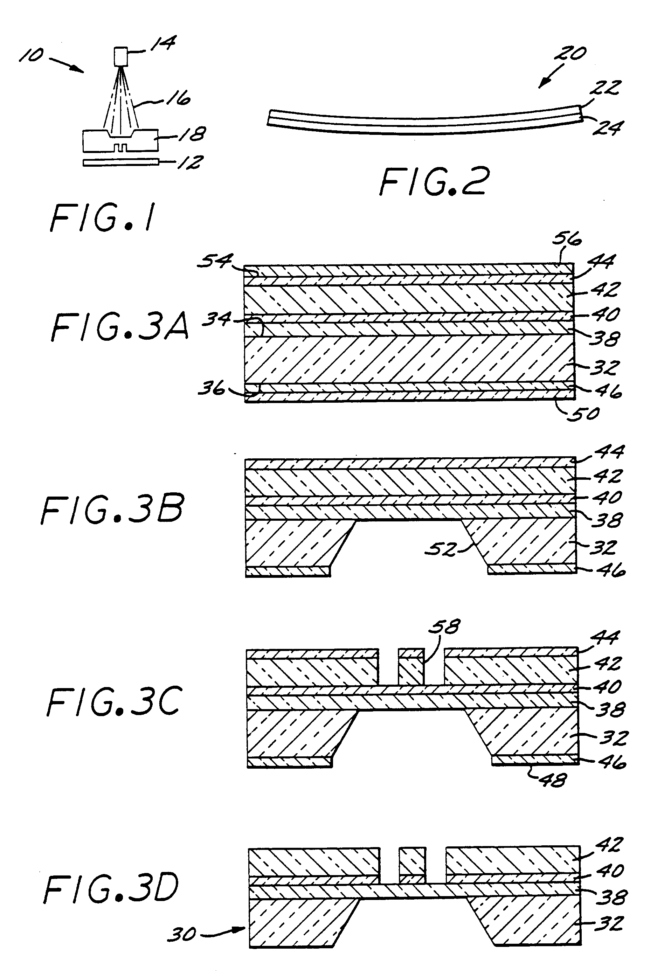

The present invention is used in conjunction with apparatus 10 for patterning a semiconductor target 12, as depicted in Figure 1. The apparatus 10 includes a flood radiation source, here illustrated as ion beam source 14. The source 14 produces a beam 16 of ions of selected energy and dose rate, that are implanted into the target 12. To produce a pattern of implanted ions, the beam 16 is passed through a mask 18 disposed between the source 14 and the target 12. The mask 18 is structured so that only a portion of the beam 16, in a selected geometric pattern, can pass through passages therein, with the rest of the ions in the beam 16 blocked.

The mask 18 must be capable of passing the desired portion of the beam 16, and blocking the remaining portion of the beam. To achieve very high resolution features on the surface of the target 12, the linewidth of the portion of the beam 16 that is passed may be very small, on the order of less than 0.5 micrometer. Consequently, the mask 18 must be capable of having passages for the beam 16 that are this narrow. Since the ions in the beam 16 can be scattered by their interaction with the passages through the mask 18, the passages must be structured to minimize such scattering and maximize the sharpness and resolution of the beam.

In one approach to making a mask 20, as illustrated in Figure 2, an absorber layer 22 is provided on a crystalline silicon substrate 24. The absorber layer 22 can be any absorbent material, such as gold, tungsten, or silicon. A brief description of this approach to fabricating such masks is provided by way of background, and so that key differences can be later emphasized. The mask starts with a layer of silicon, preferably (001) orientation. Layers of silicon dioxide are grown on the top and bottom surfaces, and the top layer is etched. Boron is diffused into the top surface to form a layer of borosilicate glass on the top surface. The glass layer is etched from the top surface back to the region of high boron concentration.

A resist layer is applied to the bottom surface of the mask over the silicon dioxide layer. A window is etched in the silicon dioxide layer using the resist layer. A 500 Angstrom layer of chromium and a 7000 Angstrom layer of gold are deposited on the top of the boron layer, in the case of making a gold absorber layer. A resist layer is applied and then the exposure pattern is formed in the gold. The gold exposed by the pattern is removed by ion beam milling, and a 200 Angstrom layer of chromium is applied. This critical and costly step of pattern development in the gold is an intermediate step, with further process steps to follow. If any of the later process steps fails, then the effort expended in the pattern formation step is lost.

Next, the silicon membrane is thinned to the boron doped layer by etching from the back side through the window previously formed. The chromium and silicon dioxide are removed by chemical etching, and the mask is mounted in a support to complete the process.

Implementation of this process requires some 22 different process steps. The critical pattern formation is followed by other steps, increasing the chances that the expenditures made in the pattern formation step will be lost by failures in succeeding steps and increasing the possibility of distortion of the pattern during subsequent steps, as by stress relaxation. The mask itself has imperfections and stresses upon fabrication. Because of its bimaterial construction of gold and silicon, the different thermal expansion coefficients cause the mask to warp and distort when repeatedly heated and cooled in use. In the simplified structure illustrated in Figure 2, the thermal expansion mismatch between the layer 22 and the substrate 24 results in warping of the mask 20, as illustrated. The warping of the mask 20 causes a largely unpredictable distortion of the pattern on the target.

The absorber layer 22 can also be made of boron-doped silicon. A layer 22 of doped silicon is deposited on the substrate 24, and layers of silicon nitride is deposited overlying the layer 22 and on the backside of the substrate 24. A window is etched through the backside silicon nitride layer and transferred to the substrate 24, stopping at the boron-doped layer 22. A pattern is then etched in the boron-doped layer 22 in the desired form, stopping the etching at the point where the remaining thickness of the boron-doped layer is judged sufficient to act as a membrane. It is difficult to simultaneously control both the pattern sidewall relaxation and the mask thermal distortion with this approach.

By contrast, the approach of the present invention has many fewer process steps than the gold-silicon mask approach, and the patterning operation is at the end of the processing. Warpage and other sources of distortion are reduced in the final mask by control of materials and relaxation. Built-in etch stop layers improve the fabricability by reducing the amount of judgment required to prepare a mask. The preferred embodiment of the invention is next described in relation to the preferred silicon mask material, but, as elsewhere discussed herein, other mask materials may be used.

In a preferred embodiment of the present invention for producing a mask 30, and as illustrated in the process flow chart of Figure 3, a silicon single crystal wafer 32 of thickness about 300 micrometers is furnished. The silicon wafer 32 should have a crystallographic orientation that permits channeling of the ion beam along the crystallographic through-thickness direction. The (001) and (011) crystallographic orientations and the corresponding [001] and [011] directions are known to have this channeling capability and are therefore preferred. Other orientations and directions meeting the requirement are also operable. The thickness of the silicon wafer 32 is not critical, inasmuch as all portions of the wafer 32 that might lie within the ion beam pattern are removed. Silicon single crystal slices of about 2 inch diameter and 300 micrometers thickness are typically used, to permit handling and because of ready availability.

The silicon wafer 32 is provided as a polished platelike slice of much larger lateral extent than thickness. The silicon wafer 32 can be described as having a top surface 34 and a bottom surface 36, and these terms will be used to provide a frame of reference for the fabrication steps illustrated in Figure 3.

A layer 38 of p-doped silicon is formed over the top surface 34 of the silicon wafer 32 by any appropriate technique such as epitaxial growth. The concentration of the dopant is preferably about 1 to 4 x 10²⁰ ions per cubic centimeter. The p-doped layer 38 has four important functions. First, it forms the actual mask material and therefore must have the proper absorbing and channeling characteristics with minimum distortion. Second, the presence of the smaller dopant ions induces tensile stress in the layer 38 which is beneficial to retaining the pattern in the finished mask during heating by the ion beam in lithographic processes. Third, the doped layer 38 acts as an etch stop for etchants used in the process. Fourth, the layer 38 has a structural function in supporting portions of the mask 30, and must have sufficient strength for this purpose.

The layer 38 of p-doped silicon is about 0.5 micrometers thick as deposited. This thickness is sufficiently small to pass the ion beam in the regions where it is to be passed, but strong enough to support the remaining structure of the mask 30 with minimal distortion.

The dopant for the silicon is any p-type dopant whose ionic size in silicon is less than that of the silicon itself, so that the doped deposited layer has a tensile prestress. Boron is preferred, because of its small size and established doping technology. Other p-type dopants such as aluminum are also thought to be operable.

In the preferred approach, a layer of boron-doped silicon 38 is deposited upon the top surface 34 of the wafer 32 by plasma assisted chemical vapor deposition of a mixture of a diborane and silane at 1000°C. The wafer 32 is placed into a chemical vapor deposition (CVD) reactor and heated to 1000°C. A flow of gas containing about 105 standard cubic centimeters per minute (sccm) of 2700 ppm diborane in hydrogen, 60 sccm of silane, and 60 liters per minute of the hydrogen carrier gas is passed over the wafer. Boron-doped silicon is deposited on the wafer as the layer 38 at the rate of about 1000 Angstroms per minute for a period of 30 minutes to form a 3 micrometer layer.

A layer of silicon dioxide (SiO₂) 40 is then provided overlying the doped layer 38. The layer 40 is formed by oxidizing the uppermost portion of the layer 38 in steam at a temperature of about 900°C. The silicon dioxide layer 40 is preferably about 100 to 150 Angstroms thick.

A layer of amorphous silicon 42 is then provided overlying the layer 40. The amorphous silicon layer 42 is formed by plasma assisted chemical vapor deposition. A gaseous mixture of 10 sccm silane and 5 sccm helium, with a total gas pressure of about 1/2 Torr is passed over the wafer 32 (with the layers 38 and 40 already deposited thereupon), which is maintained at a temperature of about 250°C in an rf plasma of about 100 watts. Amorphous silicon is deposited at a rate of about 0.5 micrometers per hour, so that the preferred thickness of about 2 micrometers is achieved in 4 hours of deposition.

An upper layer 44 of silicon nitride (Si₃N₄) is provided overlying the amorphous silicon layer 42, and a lower layer 46 of silicon nitride is provided overlying the opposite side (backside) of the wafer 32 from which the layer 38 is deposited, also termed the bottom surface 36. The layers 44 and 46 are deposited by chemical vapor deposition. The wafer 32 (with the layers 38, 40, and 42 already deposited) is placed into a chemical vapor deposition apparatus and heated to 790°C. A mixture of 100 sccm dichlorosilane and 100 sccm ammonia is flowed at a pressure of 200 millitorr. The silicon nitride layers grow at the rate of about 25 Angstroms per minute, requiring about 20 minutes to reach a thickness of 500 Angstroms.

The bottom of the as-deposited structure is next coated with a resist layer 50 of a positive photoresist material such as AZ1350J, and patterned optically. The resist layer 50 is developed using conventional procedures. The developed pattern in the lower resist layer 50 provides an opening through the resist layer 50, which is larger in lateral dimension than the ultimate mask pattern. The opening pattern is transferred to the silicon nitride layer 46 as a window 52, by reactive ion etching in carbon tetrafluoride gas. The window 52 is then transferred to the wafer 32 by removing a portion of the wafer 32, through the opening in the layer 46, with a solution formed from 250 milliliters of ethylenediamine, 80 grams pyrocatechol, 60 milliliters water, and 1.5 grams pyrazine, resulting in the structure as shown in Figure 3B. The boron-doped silicon layer 38 acts as the etch stop, as the rate of etching is greatly reduced when the etchant reaches this layer 38.

The mask pattern is then provided with high resolution lithography and selective etching. An upper surface 54 of the as-deposited structure is coated with a layer 56 of the resist material, and patterned optically or by electron beam. The resist layer 56 is developed using conventional procedures. The pattern 58 in the upper resist layer 56 is in the form of the ultimate pattern of the mask that is to be replicated in the form of implanted ions in the target 12. The pattern 58 is transferred to the silicon nitride layer 44 by reactive ion etching in carbon tetrafluoride gas. The pattern 58 is then transferred to the amorphous silicon layer 42 by magnetron ion etching in an atmosphere of chlorine and carbon tetrachloride, with the silicon dioxide layer 40 acting as the etch stop. The sides of the pattern in the layer 42 are observed to be steep and straight, and superior in this respect to the sides that can be obtained in reactive ion etching of crystalline silicon. Also, as illustrated in Figure 3C, there is little sidewall relaxation or distortion of the layer 42 as the etching proceeds, as the layer 42 has only minor stresses that would cause such relaxation.

Finally, the resist layers 50 and 56, and the silicon nitride layers 44 and 46 are removed by dipping the structure into a buffered hydrofluoric acid solution. During the preceding process steps, the thickness of the silicon nitride layers is reduced to about 200 Angstroms, and it is believed that these layers could be left in place without detrimental effects on performance of the mask. Such a thin layer has so little strength that it does not have a significantly detrimental effect on the performance of the mask during use through the creation of thermal stresses. A thin layer of a thermally emissive material such as an alloy of nickel and chromium may be added to the top surface of the mask to increase its heat emission during ion beam or x-ray lithography, when the mask is heated. Such a layer would be very thin, as about 200 Angstroms, and also would have little strength. Thus, the presence of very thin layers of silicon nitride or an emissive material would be within the concept of a substantially monolithic mask of a single material, because such layers would not have sufficient strength to create significant stresses caused by differences in coefficients of thermal expansion.

The completed mask 30 is illustrated in Figure 3D. This mask 30 is used as the mask 18 in an apparatus such as the apparatus 10 of Figure 1, to pattern targets 12 with flood ion beam illumination. The patterns in the targets 12 have high resolution linewidth, due in part to the low distortion of the mask. The present process achieves low distortion of the mask by reducing warpage due to thermal stresses, and by maintaining sharp edges in the pattern 58.

The 2 micrometer thickness of the layer of amorphous silicon is chosen to stop the portion of the ion beam 16 that is not to be transmitted to the target 12. The 0.5 micrometer thickness of the p-doped silicon layer 38 is chosen to have sufficient strength and the correct magnitude of internal stress to resist thermal distortion during use of the mask. The layer 38 is thin enough to transmit the ions of the beam 16 to the target 12. The selected thicknesses depend upon the energy of the ion beam that is to be used in lithography. It is known that about 100 KEV of energy of the ion beam is lost for each 1.0 micrometer thickness of the amorphous silicon. The thickness of the amorphous silicon layer 42, about 2 micrometers, plus the thickness of the underlying portion of the p-doped silicon layer 38, is sufficient to absorb nearly all of the 225 KEV ion beam. On the other hand, only about 45 KEV of beam energy is lost in the 0.5 micrometer thickness of p-doped silicon layer 38 in the thinned regions of the exposure pattern, so that substantially all of the ion beam is transmitted by channeling through this portion, at a slightly reduced energy of about 180 KEV.

As is apparent, the mask region bearing the exposure pattern is substantially monolithic, being formed of silicon and p-doped silicon. The amorphous silicon absorber layer is added after the p-doped silicon layer is deposited, resulting in a low stress level in the amorphous silicon layer. The membrane is formed by etching away the underlying portion of the silicon wafer prior to patterning, so that any strains in the silicon wafer and membrane layer are reduced before the exposure pattern is etched into the membrane. This approach reduces the tendency of the mask and the exposure pattern to produce a distorted image during lithography. The mask of the present invention also has a significantly higher yield in mask fabrication than experienced with the prior gold/silicon masks, due to the reduced number of process steps and the placing of the pattern definition at the end of the process.

## Claims

1. A process for preparing a membrane channeling mask (30) having an exposure pattern (58) therein, comprising the steps of:
furnishing a wafer (32) of a crystalline mask material;
providing a layer (38) of doped mask material at one surface (34) of the wafer (32) of mask material, the doping ion having an ionic size such that the layer of doped mask material is in tension;
providing a layer (42) of amorphous mask material overlying the layer (38) of doped mask material;
etching a window (52) to the layer (38) of doped mask material through the undoped mask material wafer (32), the window (52) having a lateral extent at least as large as the exposure pattern (58) and extending through the thickness of the mask material wafer (32) to the layer (38) of doped mask material; and
etching the exposure pattern (58) through the layer (42) of amorphous mask material to the layer (38) of doped mask material.

2. The process of claim 1, wherein the mask material is selected from the group consisting of silicon, silicon dioxide, sapphire, and beryl.

3. The process of claim 1 or 2, wherein the mask material wafer (32) is silicon having a crystallographic orientation of (001).

4. The process of claim 1 or 2 or 3, wherein the doped mask material is silicon doped with boron ions.

5. The process of one of claims 1 to 4, including the additional step of:
providing a layer (40) of silicon dioxide overlying the layer (38) of p-doped silicon;
after said step of providing a layer (38) of epitaxial p-doped silicon and before said step of providing a layer (42) of amorphous silicon.

6. The process of one of claims 1 to 5, including the additional steps of:
providing a layer (44) of silicon nitride overlying the amophous silicon layer (42), and
providing a layer (46) of silicon nitride overlying the wafer (32) of crystalline silicon on the side opposite the layer (38) of p-doped silicon,
after said step of providing a layer (42) of amorphous silicon.

7. The process of one of claims 1 to 6, wherein the thickness of the layer (42) of amorphous silicon is about 2 µm (2 micrometers).

8. The process of claim 5, wherein the thickness of the layer (40) of silicon dioxide is less than about 20 nm (200 Angstroms).

9. The process of claim 6, wherein the thickness of each layer (44, 46) of silicon nitride is about 50 nm (500 Angstroms).

10. The process of one of claims 1 to 9, wherein said step of etching the exposure pattern (58) is accomplished by reactive ion etching of the layer (42) of amorphous silicon, and chemical etching of the layer (40) of silicon dioxide.

11. A mask prepared by the process of one of claims 1-10.

12. Use of the process of one of the claims 1 to 12 and the mask of claim 11 for preparing an integrated circuit.

## Patentansprüche

1. Verfahren zur Herstellung einer Membrankanalmaske (30) mit einer darin befindlichen Belichtungsstrukturierung (58), wobei das Verfahren die Schritte aufweist:
Bereitstellen eines Wafers (32) eines kristallinen Maskenmaterials;
Vorsehen einer Schicht (38) aus dotiertem Maskenmaterial bei einer Oberfläche (34) des Wafers (32) aus Maskenmaterial, wobei das Dotier-Ion eine derartige Ionengröße aufweist, daß sich die Schicht des dotierten Maskenmaterials in Spannung befindet;
Vorsehen einer Schicht (42) aus einem amorphen Maskenmaterial, welche die Schicht (38) aus dotiertem Maskenmaterial bedeckt;
Ätzen eines Fensters (42) in die Schicht (38) aus dotiertem Maskenmaterial durch den nichtdotierten Maskenmaterialwafer (32), wobei das Fenster (52) eine seitliche Ausdehnung von zumindest derselben Größe wie die Belichtungsstrukturierung (58) aufweist und sich über die Dicke des Maskenmaterialwafers (32) bis zu der Schicht (38) aus dotiertem Maskenmaterial erstreckt; und
Ätzen der Belichtungsstrukturierung (58) durch die Schicht (42) aus amorphem Maskenmaterial bis zu der Schicht (38) aus dotiertem Maskenmaterial.

2. Verfahren nach Anspruch 1, wobei das Maskenmaterial aus der Gruppe bestehend aus Silicium, Siliciumdioxyd, Saphir, und Beryll ausgewählt wird.

3. Verfahren nach Anspruch 1 oder 2, wobei der Maskenmaterialwafer (32) Silicium mit einer kristallographischen Ausrichtung von (001) aufweist.

4. Verfahren nach Anspruch 1 oder 2 oder 3, wobei das dotierte Maskenmaterial Silicium darstellt, welches mit Bor-Ionen dotiert ist.

5. Verfahren nach einem der Ansprüche 1 bis 4, welches den zusätzlichen Schritt aufweist:
Vorsehen einer Schicht (40) aus Siliciumdioxyd, welche die Schicht (38) aus p-dotiertem Silicium bedeckt;
nach dem Schritt des Vorsehens einer Schicht (38) aus epitaktischem p-dotierten Silicium und vor dem Schritt des Vorsehens einer Schicht (42) aus amorphem Silicium.

6. Verfahren nach einem der Ansprüche 1 bis 5, welches die zusätzlichen Schritte aufweist:
Vorsehen einer Schicht (44) aus Siliciumnitrid, welche die amorphe Siliciumschicht (42) bedeckt, und
Vorsehen einer Schicht (46) aus Siliciumnitrid, welche den Wafer (32) aus kristallinem Silicium auf der entgegengesetzten Seite der Schicht (38) aus p-dotiertem Silicium bedeckt,
nach dem Schritt des Vorsehens einer Schicht (42) aus amorphem Silicium.

7. Verfahren nach einem der Ansprüche 1 bis 6, wobei die Dicke der Schicht (42) aus amorphem Silicium etwa 2 µm (2 Micrometer) beträgt.

8. Verfahren nach Anspruch 5, wobei die Dicke der Schicht (40) aus Siliciumdioxyd geringer als etwa 20 nm (200 Angström) ist.

9. Verfahren nach Anspruch 6, wobei die Dicke von jeder Schicht (44, 46) aus Siliciumnitrid etwa 50 nm (500 Angström) beträgt.

10. Verfahren nach einem der Ansprüche 1 bis 9, wobei der Schritt des Ätzens der Belichtungsstrukturierung (58) durch reaktives Ionenätzen der Schicht (42) aus amorphem Silicium durchgeführt wird, und durch chemisches Ätzen der Schicht (40) aus Siliciumdioxyd.

11. Maske, welche durch das Verfahren nach einem der Ansprüche 1 bis 10 hergestellt ist.

12. Verwendung des Verfahrens gemäß einem der Ansprüche 1 bis 12 und der Maske gemäß Anspruch 11 zur Herstellung einer integrierten Schaltung.

## Revendications

1. Procédé de préparation d'un masque (30) de canalisation à membrane contenant un motif (58) d'exposition, comprenant les étapes qui consistent :
à fournir une tranche (32) de matière cristalline pour masque ;
à établir une couche (38) de matière dopée pour masque à une surface (34) de la tranche (32) de matière pour masque, l'ion dopant ayant une taille ionique telle que la couche de la matière dopée pour masque soit en tension ;
à établir une couche (42) de matière amorphe pour masque recouvrant la couche (38) de matière dopée pour masque ;
à graver une fenêtre (52) jusqu'à la couche (38) de matière dopée pour masque à travers la tranche (32) de matière non dopée pour masque, la fenêtre (52) ayant une étendue latérale au moins aussi grande que le motif d'exposition (58) et s'étendant à travers l'épaisseur de la tranche (32) de matière pour masque jusqu'à la couche (38) de matière dopée pour masque ; et
à graver le motif d'exposition (58) à travers la couche (42) de matière amorphe pour masque jusqu'à la couche (38) de matière dopée pour masque.

2. Procédé selon la revendication 1, dans lequel la matière pour masque est choisie dans le groupe constitué du silicium, du dioxyde de silicium, du saphir et du béryl.

3. Procédé selon la revendication 1 ou 2, dans lequel la tranche (32) de matière pour masque est en silicium ayant une orientation cristallographique de (001).

4. Procédé selon la revendication 1, 2 ou 3, dans lequel la matière dopée pour masque est du silicium dopé avec des ions bore.

5. Procédé selon l'une des revendications 1 à 4, comprenant l'étape supplémentaire qui consiste :
à établir une couche (40) de dioxyde de silicium recouvrant la couche (38) de silicium dopé p, après ladite étape d'établissement d'une couche (38) de silicium épitaxiale dopé p et avant ladite étape d'établissement d'une couche (42) de silicium amorphe.

6. Procédé selon l'une des revendications 1 à 5, comprenant les étapes supplémentaires qui consistent :
à établir une couche (44) de nitrure de silicium recouvrant la couche (42) de silicium amorphe, et
à établir une couche (46) de nitrure de silicium recouvrant la tranche (32) de silicium cristallin sur le côté opposé à la couche (38) de silicium dopé p, après ladite étape d'établissement d'une couche (42) de silicium amorphe.

7. Procédé selon l'une des revendications 1 à 6, dans lequel l'épaisseur de la couche (42) de silicium amorphe est d'environ 2 µm (2 micromètres).

8. Procédé selon la revendication 5, dans lequel l'épaisseur de la couche (40) de dioxyde de silicium est inférieure à environ 20 nanomètres (200 angströms).

9. Procédé selon la revendication 6, dans lequel l'épaisseur de chaque couche (44, 46) de nitrure de silicium est d'environ 50 nm (500 angströms).

10. Procédé selon l'une des revendications 1 à 9, dans lequel ladite étape de gravure du motif d'exposition (58) est effectuée par gravure ionique réactive de la couche (42) de silicium amorphe et gravure chimique de la couche (40) de dioxyde de silicium.

11. Masque préparé par le procédé de l'une des revendications 1 à 10.

12. Utilisation du procédé de l'une des revendications 1 à 10 et du masque de la revendication 11 pour préparer un circuit intégré.
